# EUROPEAN PATENT APPLICATION

(11) **EP 3 975 265 A1**
(43) Date of publication of application: **30.03.2022**
(21) Application number: 20198695.7
(22) Date of filing: 28.09.2020
(51) Int. Cl.: H01L 29/872, H01L 23/31, H01L 29/06, H01L 29/16, H01L 23/29, H01L 29/47

(54) **A SEMICONDUCTOR DEVICE AND A METHOD OF MANUFACTURING OF A SEMICONDUCTOR DEVICE**

(71) Applicant: Nexperia B.V., 6534 AB Nijmegen (NL)
(72) Inventor: Esteve, Romain, 6534 AB Nijmegen (NL); Böttcher, Tim, 6534 AB Nijmegen (NL)
(74) Representative: Pjanovic, Ilija

(57) **Abstract**

This disclosure relates to a semiconductor device comprising a passivation structure, wherein the passivation comprises a first silicon oxide layer, a silicon nitride layer positioned under the first silicon oxide layer, and a second silicon oxide layer positioned under the silicon nitride layer. The semiconductor device further comprises a metal contact layer, wherein the passivation structure overlaps an edge of the metal contact layer. The metal contact layer can be a Ti/TiN contact layer.

## Description

### FIELD

The present invention relates to a semiconductor device with an oxide-nitride-oxide passivation structure. The invention also relates to a method of manufacturing a semiconductor device with such an oxide-nitride-oxide passivation structure.

### BACKGROUND

Semiconductor diodes known in the art require a passivation layer. This passivation layer protects the surface of the semiconductor diodes from a chemical contamination, without disturbing the electrical performance of the semiconductor diode.

Silicon carbide (SiC) diodes are also known in the art. It is an usual objective in the semiconductor industry to provide smaller, faster, and cheaper semiconductor devices. I.e. improving performance and reducing the semiconductor device cost, while at the same time shrinking packaging size, is fundamental to virtually every semiconductor product type. For power products, improved performance is measured by increased efficiency and power density, higher power handling capability, and wider operating temperature range. Such improvements depend largely on the desirable characteristics of power components used, such as low switching and conduction losses, high switching frequency, stable electrical characteristics over a wide temperature range, high operating temperature, and high blocking voltage. As silicon power semiconductor devices are approaching their theoretical limits, compound semiconductor materials, such as SiC, provide the capability to dramatically improve these parameters.

Although silicon power products continue provide some incremental improvements, SiC devices can deliver significantly better performance.

The above mentioned passivation layer, that protects the surface of the semiconductor diodes from a chemical contamination, without disturbing the electrical performance of the semiconductor diode, is especially important for SiC diodes, because the breakdown voltages and the electric fields of the SiC diodes can be very high.

It is known in the art that silicon nitride can be used as a very efficient diffusion barrier, both for mobile ions and humidity. Silicon nitride provides also a good thermal stability. However, it is a significant disadvantage of silicon nitride that it includes a lot of traps and big amounts of interface charges, which results in destabilizing the border charge balance. Thus, the silicon nitride semiconductor interfaces have very unwanted characteristics.

Another drawback of the silicon nitride semiconductor devices is that for other materials adhesion to silicon nitride is low. This causes problems when additional layers must be used either for passivation or for other purposes.

Silicon oxide has less traps and charges and it is therefore a preferred interface layer, especially in the proximity of junctions within the semiconductor. However, the significant disadvantage of silicon oxide is that it does not block ions or other chemical contamination, and it does not protect against humidity.

Moreover, silicon oxide does not protect from a corrosion caused by humidity and a high voltage exposure.

### SUMMARY

Various example embodiments are directed to the disadvantage as described above and/or others which may become apparent from the following disclosure.

According to an embodiment of this invention a semiconductor device comprises a passivation structure. The passivation comprises a first silicon oxide layer, a silicon nitride layer positioned under the first silicon oxide layer, and a second silicon oxide layer positioned under the silicon nitride layer.

The first silicon oxide layer can be doped with a nitride, which results in an oxi-nitride layer.

The semiconductor device further comprises a metal contact layer, wherein the passivation structure overlaps an edge of the metal contact layer.

The metal contact layer is made preferably of Ti, TiN, or TaN, MoN, Pt, Au, Ag, or any other suitable material, or stacks of these materials. The top of the metal contact layer in a border region, which border region is in a contact with the environment, is made out of a non-oxidizing metal, e.g. TiN, TaN, MoN, Pt, Au, etc.

The metal contact layer is made preferably as a layer stack of Ti or any other suitable metal on the bottom of the layer stack, and a metal nitride on the top of the layer stack, wherein the metal nitride is TiN, TaN, MoN or any other suitable metal nitride.

The semiconductor device as described above provides a termination of SiC high voltage devices to be robust against humidity and charges. This is achieved by a combination of silicon oxide, silicon nitride and silicon oxide layers underneath a polyimide scratch protection, in combination with a Ti/TiN contact layer.

The second silicon oxide layer makes a reasonable interface to the silicon carbide and ensures sufficient distance of the interface from the traps and charges in the nitride diffusion barrier. The first silicon oxide layer secures an excellent adhesion to the scratch protection layer above. The remaining exposed TiN layer of the TiN contact layer is robust against corrosion.

The above described structure of a semiconductor device is especially advantageous for high voltage silicon carbide devices such as Merged-PN-Schottky (MPS) diodes and is combined with a Ti/TiN contact layer.

Moreover, the overlap of passivation and power metal is avoided. This makes the semiconductor device design robust against high-stress environments, e.g. for moulded packages.

Thus, the semiconductor device as described above is designed for a high mechanical robustness and a humidity inertness at the same time.

According to an embodiment of the invention, a semiconductor device further comprises a polyimide scratch protection structure, wherein the polyimide scratch protection structure is covering the passivation structure.

The polyimide scratch protection structure is made of 3-20 µm imide or any other suitable material.

The semiconductor device further comprises a power metal layer, which power metal layer is for example a low resistance metal layer for electric signal spread. The power metal layer can be made of Al, Ag, Cu or any other suitable material or a power metal layer stack comprising two or more of these materials.

The power metal layer stack can be arranged for soft soldering. The top of the power metal layer stack can be:
- Ni, Cu; or Ag;
- a stack of Ni and Ag;
- a stack of Ti and Ni;
- a stack of Cu and Sn;
- a stack of Ti and NiV;
- a stack of Ti, Ni and Ag; or
- a stack of Ti, NiV and Ag.

According to an embodiment of the invention the passivation structure is arranged not to cover the power metal layer.

According to another embodiment of the invention the passivation structure covers at least partly the top of the power metal layer.

According to an embodiment of the invention the first oxide layer of the passivation structure at least partly extends over the top of the top of the power metal layer.

The semiconductor device further comprises:
- a substrate,
- an epi, positioned on the substrate,
- a p-border termination,
- a p-well, and
- a p-plus contact on the top of the p-well.

The semiconductor device can be a SiC MPS Schottky diode, a high voltage diode or any other suitable semiconductor device.

The invention also relates to a method of producing a semiconductor device as described in the above embodiments.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a semiconductor device according to an embodiment of the invention;
Figure 2 illustrates a semiconductor device according to another embodiment of the invention;
Figure 3 illustrates a semiconductor device according to another embodiment of the invention;

### DETAILED DESCRIPTION

According to an embodiment of the invention, a semiconductor device comprises a termination, which termination is suitable for SiC high voltage semiconductor devices and which termination is robust against humidity and charges. According to an embodiment of the invention, this is achieved by a combination of a first silicon oxide layer, a silicon nitride layer and a second silicon oxide layer, the three layers being positioned underneath a polyimide scratch protection, in a combination with a titanium (Ti) and titanium nitride (TiN) contact layer. In a preferred embodiment it is a Ti/TiN stack, wherein Ti is in contact with a SiC and TiN on the top providing a corrosion protection.

A semiconductor device according to above embodiment provides an excellent protection from humidity, traps and charges. This is achieved by the second silicon oxide layer, which second silicon oxide layer makes a reasonable interface to the silicon carbide and ensures sufficient distance of the interface from the traps and charges in the nitride diffusion barrier. The top layer of silicon oxide gives good adhesion to the scratch protection layer above. The remaining exposed TiN layer is robust against corrosion.

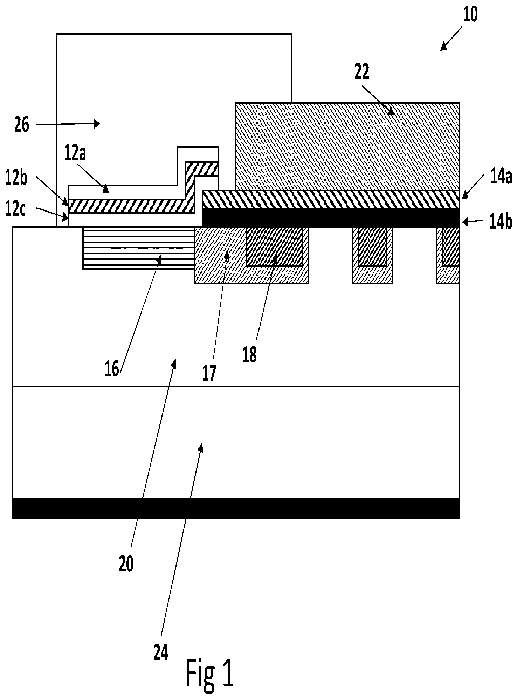

An embodiment of the invention is shown in Figure 1. A semiconductor device 10 comprises a oxide-nitride-oxide passivation structure 12a, 12b, 12c. The oxide-nitride-oxide passivation structure comprises a first silicon oxide layer 12a, a silicon nitride layer 12b and a second silicon oxide layer 12c. These three layers 12a, 12b, 12c form the passivation structure that is suitable, among other semiconductor devices, for high voltage silicon carbide, or MPS Schottky, diodes. The semiconductor device 10 further comprises a Ti/TiN contact layer 14a, 14b.

The silicon nitride layer is arranged to block ions and humidity. The silicon nitride is full of traps and for this reason has to be relatively thin, so that the charge in proximity of the termination is reduced.

Moreover, said silicon nitride is preferably kept away from the silicon carbide (SiC) in order to decouple the SiC surface from the traps and charges, thereby lowering the impact of the charge.

The first silicon oxide layer provides an increased adhesion to a polyimide.

As shown in Figure 1, a termination design of the semiconductor device comprises the oxide-nitride-oxide passivation structure 12a, 12b, 12c and a Ti/TiN contact layer 14a, 14b. The oxide-nitride-oxide passivation structure 12a, 12b, 12c is covered by a polyimide scratch protection 26.

The oxide-nitride-oxide passivation structure 12a, 12b, 12c overlaps the edge of the Ti/TiN contact layer 14a, 14b and the edge of a termination layer 16, i.e. a p-border termination 16. The oxide-nitride-oxide passivation structure 12a, 12b, 12c is arranged so not to cover a soft power metal layer 22. Such an arrangement secures that no passivation cracks form under thermo and/or mechanical stress. The soft power metal layer 22 can be made of Al, Ag, Cu or any other suitable material.

The second oxide layer 12c makes a reasonable interface to the silicon carbide and ensures sufficient distance of the SiC surface interface from the traps and charges in the nitride. The thickness of this second oxide layer 12c is crucial to minimize the impact of silicon nitride bulk and interface charges.

The silicon nitride layer 12b serves as a good diffusion barrier.

The first silicon oxide layer 12a secures a good adhesion to the layer above the first silicon oxide layer 12a. In this exemplary embodiment the layer above is the polyimide scratch protection 26. The polyimide scratch protection 26 can be made of 3-20 µm imide.

The Ti/TiN contact layer 14a, 14b is preferably relatively thin and this layer is resistant against corrosion since its top surface 14a is formed by TiN, which does not corrode under humidity and high voltage conditions. In another embodiment of the present invention alternative non-oxidizing top contact metals 14a could be TaN, MoN, Pt, Au, Ag etc.

The Ti/TiN contact layer 14a, 14b is made preferably of a layer stack of Ti on the bottom of the layer stack 14b and a metal nitride on the top of the layer stack 14a, wherein the metal nitride is TiN, TaN, MoN or any other suitable metal nitride.

The semiconductor device further comprises a p-well 17, a p-plus contact 18, an epi 20 and a substrate 24 as shown in Figure 1.

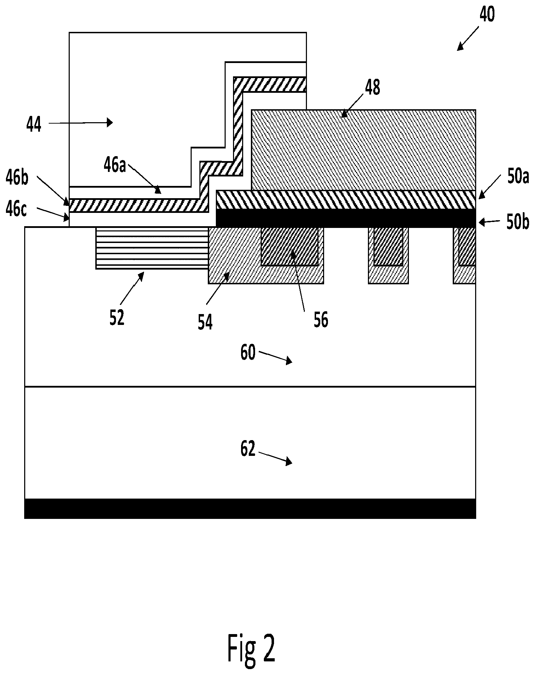

An embodiment of the invention is shown in Figure 2. A semiconductor device 40 comprises an oxide-nitride-oxide passivation structure 46 on top of a power metal contact layer 50. The power contact layer 50 can be a Ti/TiN contact. The advantage of such arrangement of the oxide-nitride-oxide passivation structure 46 in respect to the power contact layer 50 is securing the best adhesion to a polyimide scratch protection 44. Such a design of the semiconductor device 40 is suitable for module packages with gel coating, where the thermo-mechanic stress to the oxide-nitride-oxide passivation structure 46 is much lower.

According to the example embodiment shown in Figure 2, the semiconductor device 40 comprises:
- a substrate 62,
- an epi 60, positioned on the substrate 62,
- a p-border termination 52,
- a p-well 54,
- a p-plus contact 56 on the top of the p-well 54,
- a power metal contact layer 50a, 50b (e.g. a Ti/TiN contact 50a, 50b),
- an Al power metal layer 48, on the top of the power metal contact layer 50a, 50b,
- an oxide-nitride-oxide passivation structure 46a, 46b, 46c on top of a power metal contact layer 50a, 50b and on top of the Al power metal layer 48, and
- a polyimide scratch protection 44 on the top of the oxide-nitride-oxide passivation structure 46a, 46b, 46c.

The oxide-nitride-oxide passivation structure 46a, 46b, 46c comprises a first silicon oxide layer 46a, a silicon nitride layer 46b below the first oxide layer 46a and a second silicon oxide layer 46c below the silicon nitride layer 46b.

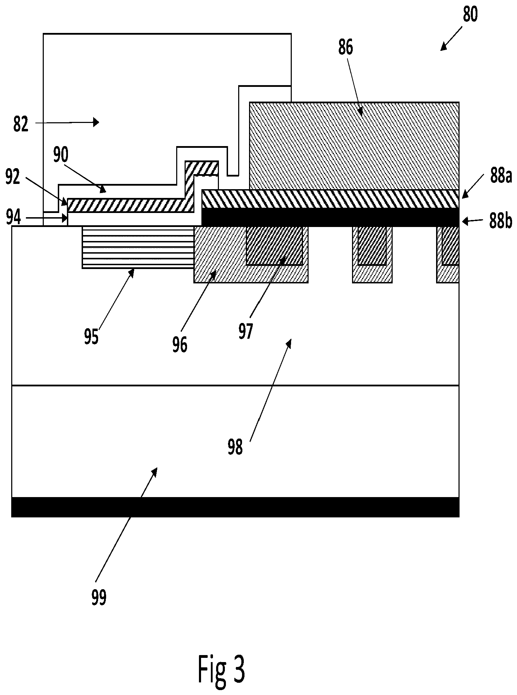

An embodiment of the invention is shown in Figure 3. A semiconductor device 80 comprises an oxide-nitride-oxide passivation structure. The oxide-nitride-oxide passivation structure comprises a first silicon oxide layer 90, a silicon nitride layer 92 partly under the first silicon oxide layer 90 and a second silicon oxide layer 94 under the silicon nitride layer 92. The semiconductor device further comprises a power metal contact layer 88a, 88b (e.g. a Ti/TiN contact layer 88a, 88b), a power metal layer 86, and a polyimide scratch protection 82.

In this embodiment of the invention the first oxide layer 90 is extended to the top of the metal layer 86. This preferred embodiment secures a good adhesion and a lower risk of passivation cracks.

The semiconductor device further comprises a p-border termination 95, a p-well 96, a p-plus contact 97, an epi 98 and a substrate 99 as shown in Figure 3.

The advantage of the above presented embodiments of the invention is that the termination design comprises the oxide-nitride-oxide passivation structure to form the advantageous passivation layer stack in combination with a robust Ti/TiN contact layer. By such an arrangement the overlap of full passivation stack and power metal is avoided. Instead, only the thin first oxide layer 90 is in contact with the power metal layer 86, which makes the semiconductor device robust against high-stress environments, as required in moulded packages, and high humidity environments, as required for gel-coated modules. Thus, at the same time a high mechanical robustness and a humidity inertness are achieved.

The invention is applicable for various semiconductor devices, especially for SiC MPS Schottky diodes, and/or any kind of high voltage diodes and other semiconductor devices.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising a passivation structure, wherein the passivation comprises:
- a first silicon oxide layer,
- a silicon nitride layer positioned under the first silicon oxide layer, and
- a second silicon oxide layer positioned under the silicon nitride layer.

2. A semiconductor device as claimed in claim 1, wherein the first silicon oxide layer is doped with a nitride.

3. A semiconductor device as claimed in claims 1 or 2, wherein the semiconductor device further comprises a metal contact layer, wherein the passivation structure overlaps an edge of the metal contact layer.

4. A semiconductor device as claimed in claim 3, wherein the metal contact layer is made preferably of Ti, TiN, or TaN, MoN, Pt, Au, Ag, or any other suitable material, or stacks of these materials.

5. A semiconductor device as claimed in claims 3 or 4, wherein the metal contact layer is preferably a layer stack comprising Ti or any other suitable metal on the bottom of the layer stack, and a metal nitride on the top of the layer stack, wherein the metal nitride is TiN, TaN, MoN or any other suitable metal nitride.

6. A semiconductor device as claimed in any of the previous claims, wherein the semiconductor device further comprises a polyimide scratch protection structure, wherein the polyimide scratch protection structure is covering the passivation structure.

7. A semiconductor device as claimed in claim 6, wherein the polyimide scratch protection structure is made of 3-20 µm imide or any other suitable material.

8. A semiconductor device as claimed in any of the previous claims, wherein the semiconductor device further comprises a power metal layer.

9. A semiconductor device as claimed in claim 8, wherein the power metal layer is made of Al, Ag, Cu or any other suitable material, or a power metal layer stack comprising two or more of these materials.

10. A semiconductor device as claimed in claim 9, wherein the power metal layer stack is arranged for soft soldering, wherein the top of the power metal layer stack is:
- Ni, Cu; or Ag;
- a stack of Ni and Ag;
- a stack of Ti and Ni;
- a stack of Cu and Sn;
- a stack of Ti and NiV;
- a stack of Ti, Ni and Ag; or
- a stack of Ti, NiV and Ag.

11. A semiconductor device as claimed in claims 8, 9 or 10, wherein the passivation structure is arranged not to cover the power metal layer.

12. A semiconductor device as claimed in claims 8, 9 or 10, wherein the passivation structure covers at least partly the top of the power metal layer.

13. A semiconductor device as claimed in claims 8, 9 or 10, wherein the first oxide layer of the passivation structure at least partly extends over the top of the top of the power metal layer.

14. A semiconductor device as claimed in any of the previous claims, wherein the semiconductor device further comprises:
- a substrate,
- an epi, positioned on the substrate,
- a p-border termination,
- a p-well, and
- a p-plus contact on the top of the p-well.

15. A semiconductor device as claimed in any of the previous claims, wherein the semiconductor device is a SiC MPS Schottky diode, a high voltage diode or any other suitable semiconductor device.

16. A method of producing a semiconductor device as claimed in any of the previous claims.
